# EUROPEAN PATENT APPLICATION

(11) **EP 4 579 393 A1**
(43) Date of publication of application: **02.07.2025**
(21) Application number: 24866596.0
(22) Date of filing: 06.08.2024
(51) Int. Cl.: G06F 1/20, H01L 23/473, H05K 7/20

(54) **LIQUID COOLING PLATE ASSEMBLY, SERVER AND DATA CENTER**

(30) Priority: 25.10.2023 CN 202311392662
(71) Applicant: Suzhou Metabrain Intelligent Technology Co., Ltd., Suzhou, Jiangsu 215000 (CN)
(72) Inventor: KUAN, Changming, Suzhou, Jiangsu 21500 (CN); WEN, Xuanying, Suzhou, Jiangsu 21500 (CN)
(74) Representative: Studio Torta S.p.A.
(86) International application number: PCT/CN2024/110125
(87) International publication number: WO 2025/086796

(57) **Abstract**

The present invention provides a liquid cooling plate assembly, a server, and a data center. The liquid cooling plate assembly includes: a cooling plate and a cover body, the cooling plate has a cavity for accommodating coolant and an interface for connecting to a liquid cooling pipe, the interface is in communication with the cavity, the cooling plate further includes a recess, and the interface is located in the recess; and the cover body covers at a location of the recess, and forms an accommodating space for accommodating an overflow liquid with the cooling plate. By the present invention, the problem of liquid leakage damage in a liquid cooling solution in the related art is solved.

## Description

### Cross-Reference to Related Application

The present invention claims the priority and the benefit of Chinese Patent Application No. 202311392662.3, filed with the China National Intellectual Property Administration (CNIPA) on October 25, 2023 and entitled "Liquid Cooling Plate Assembly, Server and Data Center", which is herein incorporated by reference in its entirety.

### Technical Field

The present invention relate to the technical field of server cooling and heat dissipation, and in particular to a liquid cooling plate assembly, a server, and a data center.

### Background

Due to current large computing demand of servers and high energy prices required by the operation of servers, thermal design power of a central processing unit (CPU) and a graphics processing unit (GPU) of the servers is also continuously increasing, and the environment of a data center is faced with a severe cooling cost problem. The design of a water cooling plate serves as a currently preferred solution. Such a design can not only effectively dissipate heat, reduce the temperatures of the central processing unit (CPU) and the graphics processing unit (GPU), but also can greatly reduce cooling power consumption, and reduce electricity consumption burden, such that the operation of the data center is more efficient and energy-saving.

In conventional air cooling environments, when facing chip slots with high thermal design power, the slope of cost raise is dramatically increased. When the thermal design power of each chip is lower than 300 watts, the cost increase is still within a reasonable range, but once the thermal design power exceeds 300 watts and 350 watts or more, the cost will increase exponentially. For example, when the thermal design power per slot reaches 400 Watts, the required cooling cost would be as high as 0.05 dollars per Watt. Thus, simply by the conventional air cooling architecture, it is difficult to cope with the heat dissipation requirements for high power consumption.

The design of the water cooling plate is advantageous in that the working temperature of the central processing unit (CPU) and the graphics processing unit (GPU) can be effectively reduced, such that the water cooling plate operates in a lower temperature range, thereby improving the operational efficiency and stability. In addition, using the water cooling solution can also significantly reduce the cooling power consumption at a cabinet level, and the reduction amplitude is up to 70%. Such an energy-saving effect not only reduces energy consumption, but also reduces dependence on a heating, ventilation and air conditioning (HVAC) system, such that the data center can still operate without starting the heating, ventilation and air conditioning (HVAC) system, thereby greatly reducing a relevant electricity consumption burden. Under such environment configuration, the power usage effectiveness (PUE) of the data center can be reduced to 1.07, thereby achieving a very excellent energy-saving effect.

However, the water cooling solution is also not without problems. The uppermost problem is the risk of liquid leakage, and the leaked liquid may lead to a short circuit of the system, thus causing a threat to the operation safety of the data center.

### Summary

The present invention provides a liquid cooling plate assembly, a server and a data center, so as to at least solve the problem of liquid leakage damage in a liquid cooling solution in the related art.

Some embodiments of the present invention provide a liquid cooling plate assembly, including: a cooling plate and a cover body, the cooling plate has a cavity for accommodating coolant and an interface for connecting to a liquid cooling pipe, the interface is in communication with the cavity, the cooling plate further includes a recess, and the interface is located in the recess; and the cover body covers at a location of the recess, and forms an accommodating space for accommodating an overflow liquid with the cooling plate.

In some embodiments, an opening of the recess faces upward, and the cover body covers above the recess.

In some embodiments, the interface is located on a bottom surface of the recess.

In some embodiments, the cooling plate includes: a body portion and a side edge portion, the body portion has the cavity, and the interface is located on an upper surface of the body portion; and the side edge portion is connected to the upper surface of the body portion and extends upwards, the side edge portion is arranged along a peripheral side of the body portion, and forms, together with the body portion, the recess having the opening facing upward.

In some embodiments, the cover body includes: a top plate and an abutting portion, the top plate covers right above the recess; and the abutting portion is connected to a lower surface of the top plate and extends downwards, and the abutting portion is provided along a peripheral side of the top plate and are abutted against and attached to an inner wall of the side edge portion.

In some embodiments, the recess and the cover body are further formed with a clearance channel for passing through of the liquid cooling pipe; and the liquid cooling plate assembly further includes a flow blocking member, the flow blocking member is arranged at the clearance channel, and blocks a space between the liquid cooling pipe and a side wall of the clearance channel.

In some embodiments, the recess includes a main body area and a clearance area, the main body area is in communication with the clearance area, the interface is located in the main body area, and the clearance area is located on a side edge of the main body area; and a portion of the cover body covers the clearance area, and forms the clearance channel together with the clearance area.

In some embodiments, a positioning structure is provided on the recess and/or the cover body, the positioning structure is located in the clearance channel, and the flow blocking member is arranged at the positioning structure.

In some embodiments, the positioning structure includes a protrusion located on the cooling plate, and the protrusion extends in a direction perpendicular to a direction in which the liquid cooling pipe penetrates into the clearance channel.

In some embodiments, there are a plurality of protrusions, at least two protrusions are arranged in the clearance channel, the plurality of protrusions are spaced apart from each other, and the flow blocking member is positioned in an interval between the plurality of protrusions.

In some embodiments, there are a plurality of clearance channels, and two opposite sides of the cooling plate are both provided with the clearance channel.

In some embodiments, the liquid cooling plate assembly further includes a liquid leakage detection member for detecting a liquid leakage state of the liquid cooling plate assembly, and the liquid leakage detection member penetrates into the recess.

In some embodiments, the recess includes a main body area and a clearance area, the main body area is in communication with the clearance area, the interface is located in the main body area, and the clearance area is located on a side edge of the main body area; a portion of the cover body covers the clearance area, and forms, together with the clearance area, the clearance channel for passing through of the liquid cooling pipe; and the liquid leakage detection member penetrates into both the main body area and the clearance area.

In some embodiments, there are a plurality of clearance channels, and two opposite sides of the cooling plate are both provided with the clearance channel; and the liquid leakage detection member sequentially passes through the clearance area and the main body area at one side, and the clearance area at the other side.

In some embodiments, the liquid leakage detection member penetrates and extends along a side edge of the recess.

In some embodiments, the liquid leakage detection member penetrates into the recess in an S shape.

In some embodiments, an opening of the recess faces upward, and the cover body covers above the recess; and the recess includes a main body area and a clearance area, the main body area is in communication with the clearance area, the interface is located in the main body area, and the clearance area is located on a side edge of the main body area; a portion of the cover body covers the clearance area, and forms, together with the clearance area, the clearance channel for passing through of the liquid cooling pipe; the liquid cooling plate assembly further includes a flow blocking member, the flow blocking member is arranged at the clearance channel, and blocks a space between the liquid cooling pipe and a side wall of the clearance channel; and the liquid cooling plate assembly further includes a liquid leakage detection member for detecting a liquid leakage state of the liquid cooling plate assembly, and the liquid leakage detection member penetrates into the recess; the liquid leakage detection member penetrates into both the main body area and the clearance area; and the liquid leakage detection member penetrates and extends along a side edge of the recess, or penetrates into the recess in an S shape.

Some other embodiments of the present invention provide a server, including the liquid cooling plate assembly as described above.

Still some other embodiments of the present invention provide a data center, including a plurality of servers as described above, the plurality of servers are electrically connected by switches.

By applying the technical solutions of the present invention, the recess is provided on the cooling plate, and the position of the interface is arranged in the recess on the cooling plate. While the interface and the cavity form a liquid path, the cavity is generally isolated from an external environment, and has no liquid path through which liquid flows to the outside. With the described arrangement, the position of the whole liquid cooling plate assembly where liquid leakage most easily occurs is a joint between the interface and the liquid cooling pipe, and the reasons therefor are: the liquid cooling pipe and the interface need to be plugged and unplugged frequently during installation and use of the liquid cooling plate; and the liquid cooling pipe is usually a hose, and therefore, no separate sealing is provided between the interface and the liquid cooling pipe, and the liquid cooling pipe is sleeved on the interface and a certain degree of sealing is achieved by using the elasticity of the hose of the liquid cooling pipe. On the basis of the situation of ease of liquid leakage at the interface, in the present invention, by providing the recess, the recess on the cooling plate is able to contain a certain amount of liquid, and therefore, even if a problem occurs in the joint between the interface and the liquid cooling pipe and results in the occurrence of liquid leakage of the coolant, the leaked coolant does not overflow directly onto various elements and related circuits in contact with the cooling plate, but accumulates in the recess on the cooling plate. Thus, the leaked coolant will cause no damage to the elements and relevant circuits, and the accumulated coolant also facilitates subsequent handling. In addition, when flowing into and out of the cavity of the cooling plate, the coolant flows through the joint between the interface and the liquid cooling pipe, and in order to enable the coolant to be inputted into the cavity and to be discharged after completing heat exchange in the cavity, the coolant inputted into the interface from the liquid cooling pipe has a certain hydraulic pressure, and correspondingly the coolant inputted into the liquid cooling pipe from the interface also has a certain hydraulic pressure. The joint between the interface and the liquid cooling pipe has a small pipe diameter and the joint is not completely sealed, and thus, the joint has a higher hydraulic pressure, and has a greater risk of liquid leakage due to the higher hydraulic pressure and the relatively weak connection manner. Moreover, when the connection between the interface and the liquid cooling pipe is not tight enough, leakage of the coolant occurs, and due to the existence of the higher hydraulic pressure, in some cases, the coolant does not gently flow out from the leakage position, but leaks in a splashing state, and the splashing coolant tends to be splashed onto various elements and related circuits, thereby causing damage thereto. In order to solve this problem, in the present invention, the cover body covers at the location of the recess on the cooling plate, and the cover body fits the recess on the cooling plate to form the accommodating space, such that the circumferential direction of the joint between the interface and the liquid cooling pipe is surrounded by the accommodating space, and such that possible splashing paths of the coolant after liquid leaks from the joint between the interface and the liquid cooling pipe are all blocked by the cover body or the cooling plate. The coolant blocked by the cooling plate still remains in the accommodating space and accumulates in the recess on the cooling plate, and the coolant blocked by the cover body and attached to the cover body flows into the recess on the cooling plate under its own gravity and accumulates in the recess, thereby preventing the splashing coolant after liquid leakage from being splashed onto various elements and related circuits and preventing same from causing damage. In summary, with the arrangements of the recess and the cover body, in the present invention, the arrangement of the recess on the cooling plate achieves accumulation of the overflow liquid generated due to liquid leakage, such that the overflow liquid will not overflow onto various elements and related circuits, thereby causing damage; and by the arrangement of the cover body, the cover body fits with the recess on the cooling plate, such that after liquid leakage occurs, the coolant will not splash onto various elements and related circuits, thereby causing damage. In addition, in the embodiment, the cooling plate has the cavity for accommodating the coolant, the cavity is connected to the liquid cooling pipe through the interface and the coolant is inputted or discharged by the fitting between the liquid cooling pipe and the interface to complete the replacement of the coolant in the cavity. Moreover, the replacement process of the coolant is the process of taking heat away to achieve the effect of cooling and heat dissipation, and old coolant with a high temperature has completed heat exchange with a heat-generating element, the heat absorption capability thereof is greatly reduced, and the old coolant needs to be replaced with a new coolant with a low temperature; thus, a new coolant continuously enters the cavity, and also an old coolant is continually discharged from the cavity and takes away the heat absorbed thereby during heat exchange with the heat-generating element. In the described arrangements, by the provision of the recess and the cover body, regardless of slow overflowing or ejecting of the liquid, liquid leaked out at the interface is able to both be accommodated in the recess, thereby perfectly covering the interface where the leakage most easily occurs, effectively preventing the liquid from ejecting into the inside of the system and causing safety risks such as short circuit, and thus the leakage and overflow problems are avoided at the source, and the stable operation of the system is ensured.

### Brief Description of the Drawings

Fig. 1 is an exploded view of a liquid cooling plate assembly according to an embodiment of the present invention;
Fig. 2 is a top view of a cooling plate and a liquid cooling pipe after being assembled according to an embodiment of the present invention;
Fig. 3 is a schematic wiring diagram of a liquid leakage detection member in a liquid cooling plate assembly according to an embodiment of the present invention;
Fig. 4 is another schematic wiring diagram of a liquid leakage detection member in a liquid cooling plate assembly according to an embodiment of the present invention;
Fig. 5 is a schematic structural diagram of a liquid cooling plate assembly according to an embodiment of the present invention;
Fig. 6 is a sectional view taken along A-A direction of Fig. 5; and
Fig. 7 is a sectional view taken along B-B direction in Fig. 5.

The figures above include the following reference signs:
10. Cooling plate; 11. Body portion; 12. Side edge portion; 20. Cover body; 21. Top plate; 22. Abutting portion; 30. Recess; 31. Main body area; 32. Clearance area; 40. Liquid cooling pipe; 50. Interface; 60. Flow blocking member; 70. Protrusion; 80. Liquid leakage detection member.

### Detailed Description of the Embodiments

It is to be noted that embodiments in the present invention and features in the embodiments may be combined with one another without conflicts. Hereinafter, the present invention is described in detail with reference to the accompanying drawings and in conjunction with the embodiments.

It is to be noted that unless otherwise indicated, all technical and scientific terms used in the present invention have the same meanings as those commonly understood by a person of ordinary skill in the art to which the present invention belongs.

In the present invention, unless specified to the contrary, directional terms such as "upper, lower, top and bottom" are generally used regarding the directions shown in the figures, or for the components themselves in vertical, perpendicular or gravity directions; likewise, for ease of understanding and description, "internal, external" refer to internal and external relative to the outline of each component itself, but the described directional terms are not used to limit the present invention.

In order to solve the problem of liquid leakage damage in a liquid cooling solution in the related art, the present invention provides a liquid cooling plate assembly, a server, and a data center.

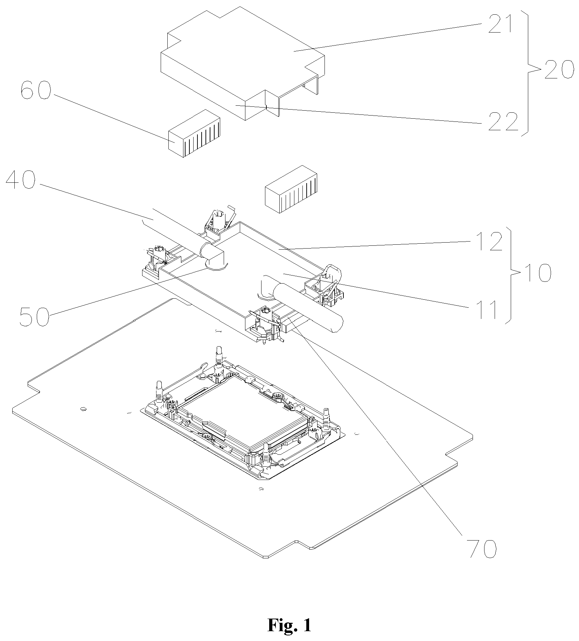

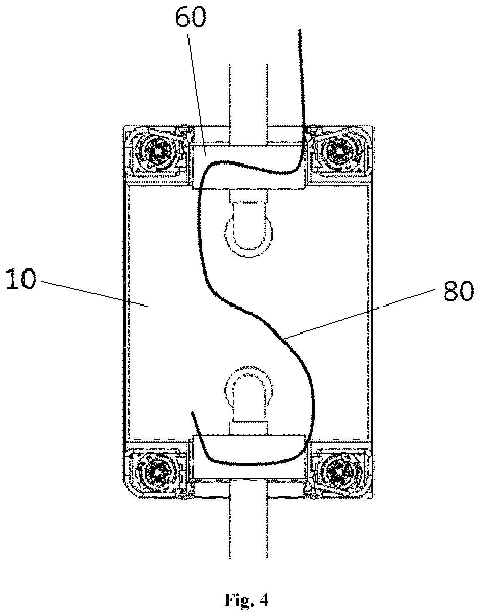

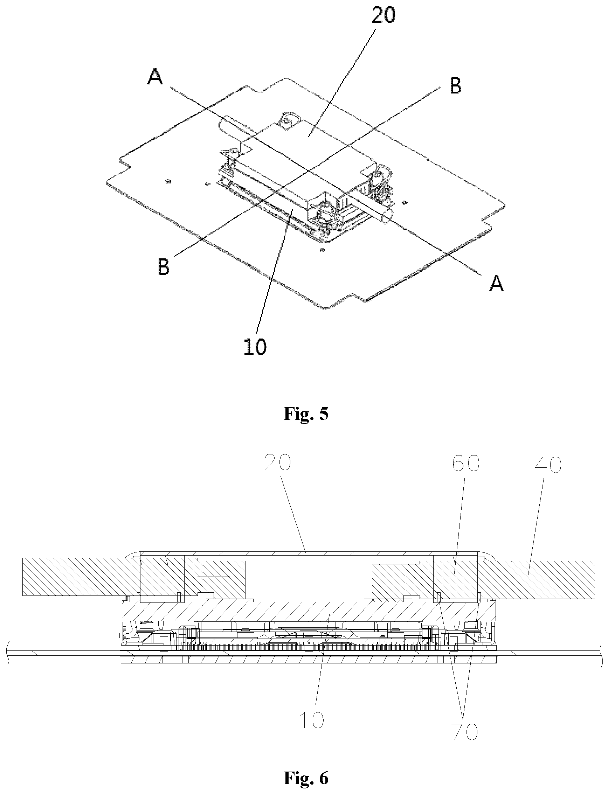

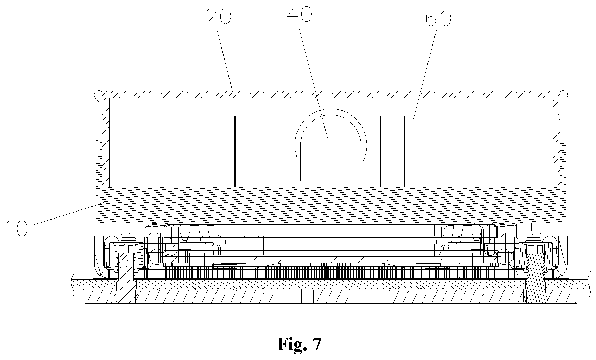

The liquid cooling plate assembly as shown in Figs. 1-7 includes: a cooling plate 10 and a cover body 20, the cooling plate 10 has a cavity for accommodating coolant and an interface 50 for connecting to a liquid cooling pipe 40, the interface 50 is in communication with the cavity, the cooling plate 10 further includes a recess 30, and the interface 50 is located in the recess 30; and the cover body 20 covers at a location of the recess 30, and forms an accommodating space for accommodating an overflow liquid with the cooling plate 10.

In the embodiment, the recess 30 is provided on the cooling plate 10, and the position of the interface 50 is arranged in the recess 30 on the cooling plate 10. While the interface 50 and the cavity form a liquid path, the cavity is generally isolated from an external environment, and has no liquid path through which liquid flows to the outside. With the described arrangement, the position of the whole liquid cooling plate assembly where liquid leakage most easily occurs is a joint between the interface 50 and the liquid cooling pipe 40, and the reasons therefor are: the liquid cooling pipe 40 and the interface 50 need to be plugged and unplugged frequently during installation and use of the liquid cooling plate 10; and the liquid cooling pipe 40 is usually a hose, and therefore, no separate sealing is provided between the interface and the liquid cooling pipe, and the liquid cooling pipe 40 is sleeved on the interface 50 and a certain degree of sealing is achieved by using the elasticity of the hose of the liquid cooling pipe 40. On the basis of the situation of ease of liquid leakage at the interface 50, in the embodiment, by providing the recess 30, the recess 30 on the cooling plate 10 is able to contain a certain amount of liquid, and therefore, even if a problem occurs in the joint between the interface 50 and the liquid cooling pipe 40 and results in the occurrence of liquid leakage of the coolant, the leaked coolant does not overflow directly onto various elements and related circuits in contact with the cooling plate 10, but accumulates in the recess 30 on the cooling plate 10. Thus, the leaked coolant will cause no damage to the elements and relevant circuits, and the accumulated coolant also facilitates subsequent handling. In addition, when flowing into and out of the cavity of the cooling plate 10, the coolant flows through the joint between the interface 50 and the liquid cooling pipe 40, and in order to enable the coolant to be inputted into the cavity and to be discharged after completing heat exchange in the cavity, the coolant inputted into the interface 50 from the liquid cooling pipe 40 has a certain hydraulic pressure, and correspondingly the coolant inputted into the liquid cooling pipe 40 from the interface 50 also has a certain hydraulic pressure. The joint between the interface 50 and the liquid cooling pipe 40 has a small pipe diameter and the joint is not completely sealed, and thus, the joint has a higher hydraulic pressure, and has a greater risk of liquid leakage due to the higher hydraulic pressure and the relatively weak connection manner. Moreover, when the connection between the interface 50 and the liquid cooling pipe 40 is not tight enough, leakage of the coolant occurs, and due to the existence of the higher hydraulic pressure, in some cases, the coolant does not gently flow out from the leakage position, but leaks in a splashing state, and the splashing coolant tends to be splashed onto various elements and related circuits, thereby causing damage thereto. In order to solve this problem, in the present invention, the cover body 20 covers at the location of the recess 30 on the cooling plate 10, and the cover body 20 fits the recess 30 on the cooling plate 10 to form the accommodating space, such that the circumferential direction of the joint between the interface 50 and the liquid cooling pipe 40 is surrounded by the accommodating space, and such that possible splashing paths of the coolant after liquid leaks from the joint between the interface 50 and the liquid cooling pipe 40 are all blocked by the cover body 20 or the cooling plate 10. The coolant blocked by the cooling plate 10 still remains in the accommodating space and accumulates in the recess 30 on the cooling plate 10, and the coolant blocked by the cover body 20 and attached to the cover body 20 flows into the recess 30 on the cooling plate 10 under its own gravity and accumulates in the recess 30, thereby preventing the splashing coolant after liquid leakage from being splashed onto various elements and related circuits and preventing same from causing damage. In summary, with the arrangements of the recess 30 and the cover body 20, in r, the arrangement of the recess 30 on the cooling plate 10 achieves accumulation of the overflow liquid generated due to liquid leakage, such that the overflow liquid will not overflow onto various elements and related circuits, thereby causing damage; and by the arrangement of the cover body 20, the cover body fits with the recess 30 on the cooling plate 10, such that after liquid leakage occurs, the coolant will not splash onto various elements and related circuits, thereby causing damage. In addition, in the embodiment, the cooling plate 10 has the cavity for accommodating the coolant, the cavity is connected to the liquid cooling pipe 40 through the interface 50, and the coolant is inputted or discharged by the fitting between the liquid cooling pipe 40 and the interface 50 to complete the replacement of the coolant in the cavity. Moreover, the replacement process of the coolant is the process of taking heat away to achieve the effect of cooling and heat dissipation, and old coolant with a high temperature has completed heat exchange with a heat-generating element, the heat absorption capability thereof is greatly reduced, and the old coolant needs to be replaced with a new coolant with a low temperature; thus, a new coolant continuously enters the cavity, and also an old coolant is continually discharged from the cavity and takes away the heat absorbed thereby during heat exchange with heat-generating element. In the described arrangements, by the provision of the recess 30 and the cover body 20, regardless of slow overflowing or ejecting of the liquid, liquid leaked out at the interface 50 is able to both be accommodated in the recess 30, thereby perfectly covering the interface 50 where the leakage most easily occurs, effectively preventing the liquid from ejecting into the inside of the system and causing safety risks such as short circuit, and thus the leakage and overflow problems are avoided at the source, and the stable operation of the system is ensured.

As shown in Figs. 1 and 5-7, in the embodiment, an opening of the recess 30 faces upward, and a sinking direction of the recess 30 is vertical, and the recess 30 forms a three-dimensional space with an upper opening and capable of containing a liquid, wherein the three-dimensional space functions to contain a possible leaked liquid. When the cooling plate 10 is used for perform cooling and heat dissipation of various elements, the recess 30 on the cooling plate 10 contains leaked liquid that may occur in the cooling process, which corresponds to the described function of the three-dimensional space. The position where the liquid leakage most easily occurs is the joint between the interface 50 and the liquid cooling pipe 40, and the reasons therefor have been mentioned above. The interface 50 is arranged in the recess 30, and if a problem occurs in the joint between the interface 50 and the liquid cooling pipe 40 and results in the occurrence of liquid leakage of the coolant, the leaked coolant does not overflow directly onto various elements and related circuits in contact with the cooling plate 10, but accumulates in the recess 30 on the cooling plate 10. In this way, the elements and related circuits are protected from contacting the coolant, thereby leading to a short circuit and the like and damaging themselves. Moreover, the geometry of the recess 30 also enables the coolant to maintain better fluidity, thereby further increasing the heat dissipation efficiency of the system.

In addition, when flowing into and out of the cavity of the cooling plate 10, the coolant flows through the joint between the interface 50 and the liquid cooling pipe 40, and in order to enable the coolant to be inputted into the cavity and to be discharged after completing heat exchange in the cavity, the coolant inputted into the interface 50 from the liquid cooling pipe 40 has a certain hydraulic pressure, and correspondingly the coolant inputted into the liquid cooling pipe 40 from the interface 50 also has a certain hydraulic pressure, and in this way, replacement of the coolant in the cavity is completed. In addition, the joint between the interface 50 and the liquid cooling pipe 40 has a small pipe diameter and the joint is not completely sealed, and thus, the joint has a higher hydraulic pressure, and the joint has a greater risk of liquid leakage due to the higher hydraulic pressure and the relatively weak connection manner. Moreover, when the connection between the interface 50 and the liquid cooling pipe 40 is not tight enough, leakage of the coolant occurs, and due to the existence of the higher hydraulic pressure, the coolant does not gently flow out from the leakage position, but leaks in a splashing state, and the splashing coolant tends to be splashed onto various elements and related circuits, thereby causing electrical damage thereto. For the reasons described above, according to the embodiment, the cover body 20 covers above the recess 30; in this way, after the cover body 20 covers above the recess 30, the cover body is able to completely cover the upper opening of the recess 30, and fit the recess 30 on the cooling plate 10 to block all possible splashing directions of the leaked liquid, such that the leaked liquid is accumulated in the recess 30 under the action of the recess 30 and the cover body 20, so as to be isolated from various elements and related circuits for the liquid cooling plate assembly. When liquid leakage occurs, the fitting between the recess 30 and the cover body 20 is able to protect various elements and related circuits from being affected by the liquid leakage of the liquid cooling plate assembly, and the leaked liquid is gathered to facilitate handling.

In the embodiment, the interface 50 is located on a bottom surface of the recess 30, such that the coolant overflowing out directly enters the recess 30 and is gathered at the bottom of the recess 30, thereby ensuring the effect of storing the coolant in the recess 30. In an embodiment, the position of the interface 50 in the recess 30 is able to be adjusted as needed, and it is ensured that the coolant overflowing from the interface 50 is able to directly enter the recess 30. Considering that the cavity generally has one inlet and one outlet, in the embodiment, two interfaces 50 are provided, and the two interfaces 50 are respectively arranged at two ends of the cooling plate 10; and the two interfaces 50 are respectively abutted against and fitted with a liquid cooling pipe 40 for liquid inlet and a liquid cooling pipe 40 for liquid outlet, so as to achieve the circulation of the coolant. In the embodiment, the two interfaces 50 have different functions, one interface 50 is responsible for discharging coolant that has completed heat exchange out of the cavity of the cooling plate 10, and the other interface 50 is responsible for introducing new coolant into the cavity of the cooling plate 10. With the arrangement of the two interfaces 50, replacement of the coolant in the cavity of the cooling plate 10 is completed; moreover, the replacement process of the coolant is also a process of taking heat away to achieve the cooling and heat dissipation of each element. Which specific interface 50 has which function depends on the flow direction in the liquid cooling pipe 40 connected thereto. Taking one of the two interfaces 50 as an example, when the flow direction in the liquid cooling pipe 40 connected thereto is to input the coolant into the cavity of the cooling plate 10, the function of this interface 50 is to be responsible for introducing new coolant into the cavity of the cooling plate 10; while the other interface 50 is connected to a liquid cooling pipe 40 in which the flow direction is to output the coolant out of the cavity of the cooling plate 10, and the function thereof is to discharge the coolant that has completed heat exchange out of the cavity of the cooling plate 10. It should be noted that during use, the two interfaces 50 are not able to have the same function simultaneously, and it is necessary that one interface 50 is responsible for introducing new coolant into the cavity of the cooling plate 10, and the other interface 50 is responsible for discharging the coolant that has completed heat exchange out of the cavity of the cooling plate 10. However, before the installation is completed, the two interfaces 50 may exchange with each other for installation and use. In other words, each interface 50 may be connected to a liquid cooling pipe 40 for inputting the coolant into the cavity of the cooling plate 10 and is responsible for introducing new coolant into the cavity of the cooling plate 10, and the each interface may also be connected to a liquid cooling pipe 40 having a flow direction of outputting the coolant out of the cavity of the cooling plate 10, and is responsible for discharging the coolant that has completed heat exchange out of the cavity of the cooling plate 10. It is only necessary to ensure that the two interfaces 50 correspond to two functions, respectively. With such an arrangement, during installation and use, the liquid cooling plate assembly does not need to consider which interface 50 is connected to which liquid cooling pipe 40, it is only necessary to connect one interface 50 to a liquid cooling pipe 40 having a flow direction of inputting the coolant into the cavity of the cooling plate 10, and to connect the other interface 50 to a liquid cooling pipe 40 having a flow direction of outputting the coolant out of the cavity of the cooling plate 10, which is more convenient during installation and use; and it is unnecessary to distinguish the functions of the liquid cooling pipes 40 when installing and using the liquid cooling plate assembly.

In the embodiment, the recess 30 is located at an upper portion of the cooling plate 10, that is, the cavity is located below the recess 30; therefore, the interface 50 is longitudinally arranged to penetrate through the upper surface of the cooling plate 10. In consideration that when connected, the liquid cooling pipe 40 generally extends transversely into the recess 30, an adapter portion is provided at the interface 50 in the embodiment; the adapter portion may be an additionally-provided component, and may also be a portion of the liquid cooling pipe 40. The adapter portion includes two sections, which are a first section and a second section, respectively; and both the first section and the second section are circular pipes with a hollow central portion. One end of the first section is in communication with the cavity for accommodating the coolant, and an axial direction of the first section has a certain included angle with a horizontal direction, and the first section is entirely located above the vertical direction of the cavity. One end of the second section is connected to the other end of the first section, and a certain included angle is formed between the axial direction of the second section and the axial direction of the first section; and the axial direction of the second section is horizontal, the other end of the second section is connected to the liquid cooling pipe 40, and a liquid path for the coolant to flow is formed among the cavity, the first section, the second section and the liquid cooling pipe 40. The liquid path is also a liquid path through which the coolant flows when the coolant in the cavity is replaced. It should be noted that, the first section has a certain included angle with the horizontal direction, and therefore, the first section must have one end at a higher position in the vertical direction and one end at a lower position in the vertical direction; wherein the end of the first section connected to the cavity for containing the coolant as described above is the end at a lower position in the vertical direction, and the end of the first section connected to the second section as described above is the end at a higher position in the vertical direction. Since the interface 50 of the embodiment is opened longitudinally, the first section is also arranged longitudinally, the first section is a section which is inserted into the interface 50 and is in direct communication with the cavity, the second section is a section connected to the liquid cooling pipe 40, and the two sections form an L-shaped structure. Certainly, whether the adapter portion is provided is able to be adjusted correspondingly as needed, and the specific structure thereof is able to also be adjusted correspondingly, which is not limited to the arrangement above in the embodiment.

In the embodiment, the cooling plate 10 includes a body portion 11 and a side edge portion 12, the body portion 11 has a rectangular plate-shaped structure, the body portion 11 has the cavity, the cavity is located in the rectangular plate-shaped structure, and when the liquid cooling plate assembly is used, the body portion 11 of the cooling plate 10 is placed horizontally, and the maximum two surfaces thereof are perpendicular to the vertical direction; the interface 50 is provided on the upper surface of the cooling plate 10, and the interface 50 is an inlet and an outlet for inflow and outflow of the coolant in the cavity, respectively. Except the interface 50, the coolant in the cavity is not in communication with the environment outside the cooling plate 10, and the adapter portion is located on the upper surface of the body portion 11 and is fixedly connected to the body portion 11 by the interface 50, and such connection is accomplished by fitting between the first section and the interface 50. The first section and the interface 50 have installation structures fitting each other, for example, the first section is provided with an external thread, and the interface 50 is provided with an internal thread. Definitely, the fitting installation manner between the interface 50 and the interface 50 is not limited thereto, and other fitting installation manners may also be selected. The connection between the first section and the interface 50 achieves a sealing connection as far as possible, and the joint therebetween avoids, as far as possible, a gap through which a liquid is able to pass. In order to achieve the described sealing effect, a sealing member such as a sealing ring is provided at the joint between the first section and the interface 50. In the embodiment, the body portion 11 is made of a material with good thermal conductivity, and the lower surface of the body portion 11 contacts the heat-generating element and exchanges heat with the heat-generating element, so as to absorb heat and transfer the heat to the coolant in the cavity; and then by replacement of the coolant, the coolant that has completed heat exchange is taken away while the heat of the heat-generating element is taken away, thereby achieving cooling and heat dissipation of the heat-generating element. It should be noted that the input and output of the coolant are both completed through the connection between the interface 50 and the liquid cooling pipe 40. In the process of using the liquid cooling plate assembly, the lower surface of the body portion 11 of the cooling plate 10 is in contact with the element, and completes cooling and heat dissipation of the element by heat exchange. In order to improve the use effect of the liquid cooling plate assembly, in the embodiment, the body portion 11 is made of a material with good thermal conductivity, such that during the heat exchange, as an intermediate medium between the coolant and the heat-generating element, the body portion 11 conducts heat more quickly and more efficiently, and then the liquid cooling plate assembly has a better effect of cooling and heat dissipation of the heat-generating element.

Different from the described body portion 11 horizontally arranged, the side edge portion 12 of the embodiment is a plate-shaped structure surrounding the upper surface of the body portion 11, the side edge portion 12 is vertically arranged, the side edge portion 12 extends along the direction perpendicular to the upper surface of the body portion 11 to form the height of the side edge portion 12. In other words, the side edge portion 12 is connected to the upper surface of the body portion 11, and extends upwards and has a certain height. In the embodiment, the side edge portion 12 is arranged at an edge of the top of the body portion 11, and the side edge portion 12 is arranged along the peripheral side of the body portion 11, and form, together with the body portion 11, the recess 30 having the opening facing upward, such that the recess 30 has a larger size, and the size of the body portion 11 is effectively utilized.

It should be noted that the three-dimensional space capable of containing liquid as mentioned above is enclosed by the upper surface of the body portion 11 and the side edge portions 12 arranged around the periphery of the body portion 11. The body portion 11 of the cooling plate 10 as mentioned above has a length direction, a width direction and a thickness direction, wherein the thickness direction is vertical, the length direction is parallel to the long sides of the maximum two surfaces of the body portion 11, and the width direction is parallel to the short sides of the maximum two surfaces of the body portion 11. The number of interfaces 50 as mentioned above is two, and the two interfaces 50 are respectively arranged at two ends of the cooling plate 10; the two ends of the cooling plate 10 as mentioned above refer to two ends in the length direction of the upper surface of the body portion 11, and a connecting line between the two interfaces 50 is parallel to the length direction of the body portion 11. In addition, the two interfaces 50 are located in the middle of the width direction of the body portion 11, and the two interfaces 50 are arranged symmetrically relative to the center of the body portion 11; such a symmetrical arrangement is for the convenience of subsequent installation and use, the arrangement position of the described adapter portion is the same as that of each interface 50; and the first section is fixedly connected to the body portion 11 by fitting with the interface 50 and is in communication with the cavity to form a liquid path for the coolant to flow, and finally a liquid path including the cavity, the first section, the second section, and the liquid cooling pipe 40 is formed.

In the embodiment, the cover body 20 includes: a top plate 21 and an abutting portion 22, the top plate 21 covers right above the recess 30; the abutting portion 22 is connected to the lower surface of the top plate 21 and extends downwards, and the abutting portion 22 is arranged along a peripheral side of the top plate 21. On the premise of installation the cover body 20 and the recess 30 together, the abutting portion 22 is abutted against and attached to an inner wall of the side edge portion 12. The top plate 21 of the cover body 20 has a rectangular sheet structure, and the length and width of the top plate 21 are substantially equal to the length and width of the body portion 11 of the cooling plate 10, and in the embodiment, the size of the top plate 21 is slightly smaller. In this way, the abutting portion 22 extending downwards from the edge of the top plate 21 is located within the range of the recess 30, such that after the cover body 20 is installed on the recess 30, the top plate 21 covers directly above the recess 30; and the abutting portion 22 is located on the inner side of the side edge portion 12 and is abutted against and attached to the inner wall of the side edge portion 12. The length direction and the width direction of the top plate 21 are respectively aligned with the length direction and the width direction of the body portion 11 in the vertical direction, thereby forming a complete accommodating space; and all the periphery of the accommodating space is shielded by components, such that leaked liquid is always located in the accommodating space, and is finally gathered in the recess 30 under the action of gravity. The reason of providing the abutting portion 22 at the inner side of the side edge portion 12 is: considering that a portion of the leaked liquid may be ejected at the side edges of the recess 30 or the cover body 20, if the abutting portion 22 is located on the outer side of the side edge portion 12, a portion of the liquid may flow down along the abutting portion 22 and overflow to the outside of the accommodating space. However, according to the embodiment, even if the leaked liquid is ejected, the leaked liquid is able to only be ejected on the abutting portion 22 and is able to only flow into the recess 30 along the abutting portion 22, thereby achieving the effect of preventing the leaked liquid from overflowing out of the accommodating space, and ensuring the effect of preventing the leaked liquid from damaging the circuit.

In the embodiment, in addition to the described functions, the abutment attachment and abutment installation between the abutting portion 22 and the side edge portion 12 are also able to achieve the function of positioning and installation of the cover body 20; but the cover body 20 and the recess 30 are not fixedly arranged relative to each other, the two are maintained in a relatively fixed state and have a certain degree of fastening, but the state is able to be changed under the action of an external force so as to release the fitting between two, thereby facilitating the detachment of the cover body 20 at any time for handling the leaked liquid accumulated in the recess 30. Moreover, sealed connection is able to be added between the cover body 20 and the recess 30, which is also able to have a certain isolation effect on the leaked liquid in the accommodating space formed thereby, thereby preventing the leaked liquid therein from affecting external elements and related circuits. When a sealing structure is provided between the cover body 20 and the recess 30, the direction of the recess 30 is not limited to opening upward, and may be opening downward or opening to one side.

In the embodiment, the recess 30 and the cover body 20 are further fromed with a clearance channel for passing through of the liquid cooling pipe 40. As mentioned above, the side edge portion 12 is a plate-shaped structure surrounding the upper surface of the body portion 11, and the side edge portion 12 extends along the direction perpendicular to the upper surface of the body portion 11 to form the height of the side edge portion 12. Further, the side edge portion 12 does not have the same height at respective parts around the entire body portion 11, and in the middle of two short sides parallel to the width direction on the upper surface of the body portion 11, the height of a portion of the side edge portion 12 is lower than the other portion of the side edge portion 12; alternatively, the side edge portion 12 may not be arranged at this position, and a blocking effect is achieved by a subsequent flow blocking member 60, and the latter method is adopted in the embodiment. As mentioned above, the abutting portion 22 is arranged along the peripheral side of the top plate 21, actually, the abutting portion 22 does not completely surround the whole top plate 21, and in the middle of two short sides parallel to the width direction on the lower surface of the top plate 21, a section without the abutting portion 22 is provided. The part of the body portion 11 without the side edge portion 12 and the corresponding part of the top plate 21 without the abutting portion 22 are aligned in the vertical direction, such that the two are abutted against to form the clearance channel, and the liquid cooling pipe 40 is able to penetrate into the recess 30, thereby realizing abutting against the interface 50. It should be noted that, the alignment mentioned here means that when the cover body 20 is installed on the recess 30, they are aligned with each other.

In the embodiment, the liquid cooling plate assembly further includes a flow blocking member 60, the flow blocking member 60 is arranged at the clearance channel, and blocks a space between the liquid cooling pipe 40 and a side wall of the clearance channel. In an embodiment, a flow blocking foam is selected for the flow blocking member 60, the flow blocking foam has a certain adsorption property or flow blocking property; and when liquid leakage occurs, the flow blocking foam is able to adsorb a certain amount of coolant or directly block the liquid from flowing through, such that the liquid does not flow out of the clearance channel. In addition, the flow blocking foam also has a certain elasticity, and when the flow blocking foam is installed on the clearance channel, the flow blocking foam is able to be tightly attached to the side wall of the clearance channel and the liquid cooling pipe 40 by means of its own elasticity, so as to achieve a good sealing effect. In order to ensure that the liquid cooling pipe 40 is able to pass through the flow blocking member 60, a through hole may be provided on the flow blocking member 60 in the embodiment, the liquid cooling pipe 40 passes through the through hole, and a certain sealing fit relationship also exists between an outer wall of the liquid cooling pipe 40 and the flow blocking member 60, thereby achieving a certain sealing effect, and ensuring that leaked liquid does not overflow from the through hole of the flow blocking member 60 when there is excessive leaked liquid inside the recess 30.

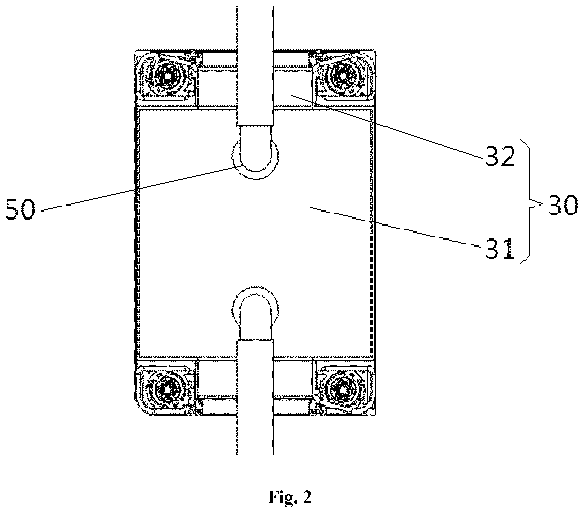

As shown in Fig. 2, in the embodiment, the recess 30 includes a main body area 31 and a clearance area 32, the main body area 31 is in communication with the clearance area 32, the interface 50 is located in the main body area 31, and the clearance area 32 is located at a side edge of the main body area 31, the side edge refer to side in the width direction of the main body area 31, i.e. the side edge corresponding to the short side of the body portion 11. The body portion 11 of the embodiment includes a middle main body part, a protruding plate is formed on the side edge in the width direction of the middle main body part, and the size of the protruding plate is less than the size of the middle main body part; and the main body area 31 is located at the middle main body part, the clearance area 32 is located at the protruding plate, and as a plurality of liquid cooling pipes 40 are arranged, there are a plurality of protruding plates. In the embodiment, the number of protruding plates is selected as two, the protruding plates are of a rectangular plate-shaped structure, and the structures of the two protruding plates are the same and are symmetrically arranged with respect to the center of the middle main body part; wherein the length direction of the two protruding plates is parallel to the width direction of the middle main body part, and the width direction thereof is parallel to the length direction of the middle main body part. In other words, the short side of the rectangular plate-shaped structure is parallel to the long side of the top plate 21, and the long side of the rectangular plate-shaped structure is parallel to the short side of the middle main body part; and the long side of the rectangular plate-shaped structure abuts against the middle portion of the short side of the middle main body part, and the short side of the rectangular plate-shaped structure is perpendicular to the short side of the middle main body part. As mentioned above, in the middle of two short sides parallel to the width direction on the upper surface of the middle main body part, the height of a portion of the side edge portion 12 is lower than the other portion of the side edge portion 12; This portion is the junction between the protruding plate and the middle main body part, and the side edge portion 12 with a height lower than that of other portions is a boundary between the protruding plate and the middle main body part.

**In** the embodiment, a portion of the cover body 20 covers the clearance area 32, and forms the clearance channel together with the clearance area 32. As mentioned above, the top plate 21 of the cover body 20 has a rectangular sheet structure, but the top plate 21 of the cover body 20 is not strictly a rectangular sheet; the two ends of the top plate 21 of the cover body 20 in the length direction are not flush, but portions protruding from the two short sides are provided in the middle of the two short sides of the top plate 21. Furthermore, the protruding portions also have a rectangular sheet structure, and the two portions have the same structure and are arranged symmetrically with respect to the center of the top plate 21; and the length direction of the two portions is parallel to the width direction of the top plate 21, and the width direction of the two portions is parallel to the length direction of the top plate 21. **In** other words, the short side of the rectangular sheet structure is parallel to the long side of the top plate 21, and the long side of the rectangular sheet structure is parallel to the short side of the top plate 21; and the long side of the rectangular sheet structure abuts against the middle of the short side of the top plate 21, and the short side of the rectangular sheet structure is perpendicular to the short side of the top plate 21. As mentioned above, the abutting portions 22 are arranged along the peripheral side of the top plate 21, and the abutting portion 22 does not completely surround the whole top plate 21, and in the middle of two short sides parallel to the width direction on the lower surface of the top plate 21, a section without the abutting portion 22 is provided. This portion is a portion where the top plate 21 abuts against the protruding rectangular sheet structure; in this case, the abutting portion 22 is arranged on the short side of the protruding rectangular sheet structure, and the abutting portion 22 is connected to the middle on the short side of the top plate 21. **In** other words, the abutting portion 22 is arranged at the entire perimeter of the top plate 21 including the protruding rectangular sheet structure, except the long side of the protruding rectangular sheet structure which is not abutted against the short side of the top plate 21.

It should be noted that the length direction of the main body area 31 is practically the same as the length direction of the body portion 11. The junctions between the main body area 31 and the clearance area 32 are actually the middle parts of the two short sides parallel to the width direction on the upper surface of the middle main body part of the body portion 11 as mentioned above; and the height of the side edge portions 12 at the two parts is lower than that of the side edge portions 12 at the other parts, or no side edge portion 12 is arranged at said two parts. It should be further noted that, as mentioned above, a portion of the cover body 20 covers the clearance area 32, and forms the clearance channel together with the clearance area 32. It means that the protruding rectangular sheet structure of the cover body 20 is located above the clearance area 32, and forms the clearance channel together with the recess 30, and certainly, this is achieved on the premise of fitting installation between the cover body 20 and the recess 30. In the embodiment, a positioning structure is provided on the recess 30 and/or the cover body 20, the positioning structure is located in the clearance channel, and the flow blocking member 60 is provided at the positioning structure. In an embodiment, the positioning structure is arranged on the recess 30 rather than the cover body 20, and the flow blocking member 60 is able to be installed at a predetermined position under the effect of the positioning structure.

In the embodiment, the positioning structure includes a protrusion 70 located on the cooling plate 10, and the protrusion 70 extends in a direction perpendicular to a direction in which the liquid cooling pipe 40 penetrates into the clearance channel. As mentioned above, the side edge portion 12 is not arranged all around the periphery of the body portion 11, but a portion of the middle of two short sides parallel to the width direction on the upper surface of the middle main body part of the body portion 11 is not provided with a side edge portion 12, and the protrusion 70 is arranged at the position where the side edge portion 12 is not arranged. That is to say, the positioning structure is located in the clearance area 32, the protrusion 70 is located on the upper surface of the protruding plate, and the protrusion 70 may or may not abut against the side edge portion 12. In the embodiment, the protrusion 70 abuts against the side edge portion 12; and as the height of the protrusion 70 is lower than that of the side edge portion 12, the liquid cooling pipe 40 is able to smoothly pass over the protrusion 70 and enter the recess 30.

In the embodiment, there are a plurality of protrusions 70, at least two protrusions 70 are arranged in the clearance channel, the plurality of protrusions 70 are spaced apart from each other, and the flow blocking member 60 is positioned in an interval between the plurality of protrusions 70. As mentioned above, the clearance area 32 is located on the protruding plate at both sides of the length direction of the body portion 11, and further, the short side of the protruding plate is also provided with the side edge portion 12 having the same height as that of the side edge portion 12 on the middle main body part. In an embodiment, two protrusions 70 are provided in a single clearance channel, and the two protrusions 70 are sequentially arranged at an interval in a direction in which the liquid cooling pipe 40 penetrates into the recess 30, such that an interval is formed between the two protrusions 70, and the flow blocking member 60 is positioned in the interval between the two protrusions 70. For a single clearance channel, one of the two protrusions 70 abuts against the side edge portion 12 of the short side of the middle main body part, such that the protrusion 70 and the side edge portion 12 are arranged continuously along the circumferential direction of the middle main body part; and the other protrusion 70 is not located at the boundary between the middle main body part and the protruding plate, and thus the other protrusion 70 is substantially located inside the clearance area 32, and two sides thereof are connected to the side edge portion 12 of the short side of the protruding plate, such that the protrusion 70 and the side edge portion 12 together form a whole. By the positioning effect of the two protrusions 70, the installation and fixation of the flow blocking member 60 are achieved, and the position of the flow blocking member 60 is ensured to be stable and reliable. In addition to the function of positioning the flow blocking member 60, the protrusion 70 is also able to provide a certain blocking effect for liquid leakage.

In the embodiment, there are a plurality of clearance channels, and two opposite sides of the cooling plate 10 are both provided with the clearance channel. In an embodiment, the number of clearance channels is two, and the two clearance channels are respectively arranged at two sides of the length direction of the cooling plate 10. It should be noted that the length direction of the cooling plate 10 coincides with the length direction of the main body and the length direction of the top plate 21. Two positions on the described body portion 11 are connected to the protruding plate, and the protruding plate is provided with the clearance area 32; two positions on the described top plate 21 are each provided with a portion protruding from the short side of the top plate 21 where the two positions are located; and the two portions on the top plate 21 cover two different clearance areas 32, and form two clearance channels together with the two clearance areas 32. Furthermore, the side edge portion 12 on the protruding plate is attached to and abutted against the abutting portion 22 protruding from the portion of the short side of the top plate 21 where the side edge portion is located, to form a side wall of the described clearance channel.

In the embodiment, the liquid cooling plate assembly further includes a liquid leakage detection member 80 for detecting a liquid leakage state of the liquid cooling plate assembly, and the liquid leakage detection member 80 penetrates into the recess 30. In an embodiment, a liquid leakage detection line is selected as the liquid leakage detection member 80 to detect the liquid leakage condition, and the principle thereof is that after leaked liquid contacts the liquid leakage detection line, the impedance of the liquid leakage detection line changes, such that a corresponding electric signal in a circuit loop connected to the liquid leakage detection line changes, thereby issuing an early warning of the liquid leakage condition of the liquid cooling plate assembly.

In the embodiment, the liquid leakage detection member 80 penetrates into both the main body area 31 and the clearance area 32. The liquid leakage detection line serving as the liquid leakage detection member 80 passes through the main body area 31 and the clearance area 32 as many as possible, such that the liquid leakage detection line is able to contact leaked liquid as far as possible when liquid leakage occurs in the liquid cooling plate assembly, so as to issue an early warning, to avoid the situation where leakage occurs in the liquid cooling plate assembly but the liquid leakage detection line is not able to contact the leaked liquid and is not able to issue an early warning, which ensures omnidirectional monitoring of liquid leakage; and even there is a small amount of liquid leaking to the outside, the liquid leakage is also able to be detected in time. Once a liquid leakage event occurs, the liquid leakage detection line immediately issues an alarm signal to notify an operator to handle the liquid leakage, thereby preventing an accident from expanding or becoming a more serious safety problem.

In the embodiment, there are a plurality of clearance channels, and two opposite sides of the cooling plate 10 are both provided with the clearance channel; and the liquid leakage detection member 80 sequentially passes through the clearance area 32 and the main body area 31at one side, and the clearance area 32 at the other side. In an embodiment, corresponding to the described arrangement, the number of clearance channels is two, and the two clearance channels are respectively located at two sides of the length direction of the cooling plate 10. The liquid leakage detection member 80 selects the liquid leakage detection line, and the liquid leakage detection line needs to be connected to a detection circuit, and therefore on this basis, when the arrangement manner of the liquid leakage detection line is selected, a feasible routing mode of the liquid leakage detection line needs to be considered, such that the liquid leakage detection line is able to be connected to the detection circuit; and the detection range of the liquid leakage detection line mainly including the main body area 31 and two clearance areas 32 also need to be considered. With the described requirements, the routing manner of the liquid leakage detection line is selected as the described routing manner, that is, the liquid leakage detection member 80 successively passes through the clearance area 32 and the main body area 31 at one side, and the clearance area 32 at the other side, and the direction of the liquid leakage detection line in the clearance areas 32 is along the width direction of the cooling plate 10.

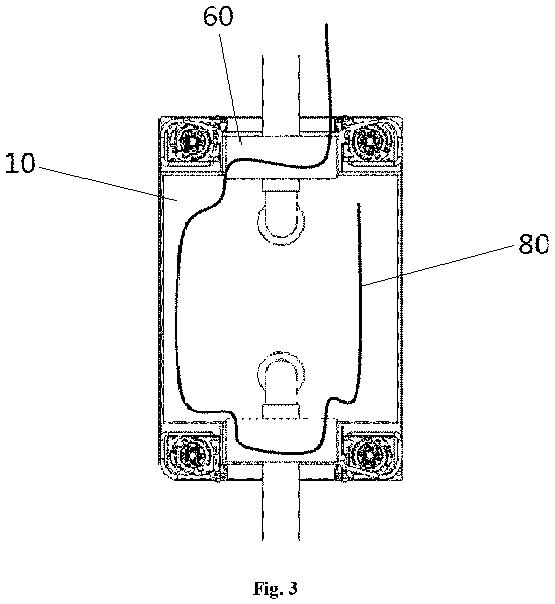

As shown in Figs. 3-4, in the embodiment, the liquid leakage detection member 80 penetrates and extends along a side edge of the recess 30. As mentioned above, when the liquid cooling plate assembly is used, the cooling plate 10 of the liquid cooling plate assembly is horizontally arranged, but the cooling plate 10 being completely horizontal is only a situation existing in an ideal condition, and under actual installation conditions, it is not realistic to install the cooling plate 10 completely horizontally. That is to say, the cooling plate 10 always inclines to a certain direction at a very small angle. In this way, the leaked liquid accumulated in the recess 30 on the cooling plate 10 may flow in the inclination direction, and accumulates at the side edges corresponding to the recess 30. Accordingly, in the embodiment, the liquid leakage detection line serving as the liquid leakage detection member 80 extends along the side edges of the recess 30. In this way, no matter where the leaked liquid in the recess 30 accumulates on the side edge of the recess 30, the liquid leakage detection line is able to contact the leaked liquid, detect the leaked liquid, and send an electric signal. As mentioned above, the liquid leakage detection member 80 extends along the side edge of the recess 30, and the liquid leakage detection member 80 sequentially passes through the clearance area 32 and the main body area 31 at one side, and the clearance area 32 at the other side, which refers to one routing manner of the liquid leakage detection line. **In** addition to the described routing manner, the liquid leakage detection member 80 may also penetrate into the recess 30 in an S shape, and the liquid leakage detection line passes through the clearance area 32 and the main body area 31 at one side, and the clearance area 32 at the other side in sequence; and the liquid leakage detection line is twisted by a certain angle in the main body area 31, such that all wiring of the liquid leakage detection line in the clearance areas 32 run along the width direction of the cooling plate 10, but the directions of current in the liquid leakage detection line in the clearance areas 32 on both sides are the same. **In** the latter routing manner, the detection range of the liquid leakage detection line also includes the main body area 31 and the two clearance areas 32. However, different from the former routing manner, the routing manner of penetrating into the recess 30 in an S shape is not as good as the former routing manner in terms of the detection of the side edge of the recess 30. However, the routing manner of penetrating into the recess 30 in an S shape has the function of detecting the center of the recess 30, but the former routing manner makes the detection range of the liquid leakage detection line not include the area of the center of the recess 30. For detection accuracy and timeliness, two liquid leakage detection lines are able to be selected as the liquid leakage detection member 80, and they employ the two routing manners mentioned above, such that the detection range is able to be expanded and the detection accuracy is able to be improved. Moreover, the detection results of the two liquid leakage detection lines are also able to be mutually verified, to improve the detection accuracy.

The embodiment further provides a server and a data center; the server includes the described liquid cooling plate assembly, and the liquid cooling plate assembly is installed on devices requiring heat dissipation, such as a processor of a main board; and the data center includes a plurality of servers, and nodes of the plurality of servers are electrically connected by switches, thereby implementing signal transmission.

It should be noted that, "a plurality of" in the embodiment refers to at least two.

From the description above, it can be determined that the embodiments above of the present invention achieve the following technical effects:
1. Leaked coolant accumulates in the recess on the cooling plate, and thus the leaked coolant will cause no damage to the elements and relevant circuits, and the accumulated coolant also facilitates subsequent handling.
2. The liquid is effectively prevented from ejecting into the inside of the system and causing safety risks such as short circuit, and thus the leakage problem is avoided at the source, and the stable operation of the system is ensured.
3. The geometry of the recess also enables the coolant to maintain better fluidity, thereby further increasing the heat dissipation efficiency of the system.
4. During installation and use, the liquid cooling plate assembly does not need to consider which interface is connected to which liquid cooling pipe, it is only necessary to connect one interface to a liquid cooling pipe having a flow direction of inputting the coolant into the cavity of the cooling plate, and to connect the other interface to a liquid cooling pipe having a flow direction of outputting the coolant out of the cavity of the cooling plate, which is more convenient during installation and use.
5. The body portion is made of a material with good thermal conductivity, and the liquid cooling plate assembly has a better effect of cooling and heat dissipation of the heat-generating element.
6. Even if the leaked liquid is ejected, the leaked liquid is able to only be ejected on the abutting portions and is able to only flow into the recess along the abutting portions, thereby achieving the effect of preventing the leaked liquid from overflowing out of the accommodating space, and ensuring the effect of preventing the leaked liquid from damaging the circuit.
7. The cover body and the recess are not fixedly arranged relative to each other, thereby facilitating the detachment of the cover body at any time for handling the leaked liquid accumulated in the recess.
8. When a sealing structure is provided between the cover body and the recess, the direction of the recess is not limited to opening upward, and may be opening downward or opening to one side.
9. The flow blocking foam has a certain adsorption property or flow blocking property; and when liquid leakage occurs, the flow blocking foam is able to adsorb a certain amount of coolant or directly block the liquid from flowing through, such that the liquid does not flow out of the clearance channel.
10. The flow blocking foam also has a certain elasticity, and when the flow blocking foam is installed on the clearance channel, the flow blocking foam is able to be tightly attached to the side wall of the clearance channel and the liquid cooling pipe by means of its own elasticity, so as to achieve a good sealing effect.
11. The liquid leakage detection line serving as the liquid leakage detection member is provided with a unique routing manner, and is able to contact the leaked liquid so as to detect the leaked liquid and send an electric signal.
12. Two liquid leakage detection lines are selected as the liquid leakage detection member, and they employ the two different routing manners, such that the detection range is able to be expanded and the detection accuracy is able to be improved.

Obviously, the embodiments as described above are only some of the embodiments of the present invention, and are not all the embodiments. On the basis of the embodiments in the present invention, all other embodiments obtained by a person of ordinary skill in the art without any inventive effort shall all fall within the scope of protection of the present invention.

It should be noted that the terms used herein are for the purpose of describing specific embodiments only and are not intended to limit exemplary embodiments according to the present invention. As used herein, the singular form is intended to include the plural form as well, unless the context clearly indicates otherwise, and further it should be understood that the terms "contain" and/or "include" when used in the present description, specify the presence of features, steps, operations, devices, assemblies and/or combinations thereof.

It is to be noted that the terms "first", "second", etc. in the description, claims and drawings of the present invention are used to distinguish similar objects, and are not necessarily used to describe a specific sequence or a precedence order. It should be understood that the data so used may be interchanged where appropriate so that embodiments of the present invention described herein may be implemented in sequences other than those illustrated or described herein.

The content above merely relates to preferred embodiments of the present invention, and is not intended to limit the present invention. For a person skilled in the art, the present invention may have various modifications and changes. Any modifications, equivalent replacements, improvements and the like made within the spirit and principle of the present invention shall all fall within the scope of protection of the present invention.

## Claims

1. A liquid cooling plate assembly, comprising:
a cooling plate (10), wherein the cooling plate (10) has a cavity for accommodating coolant and an interface (50) for connecting to a liquid cooling pipe (40), the interface (50) is in communication with the cavity, the cooling plate (10) further comprises a recess (30), and the interface (50) is located in the recess (30); and
a cover body (20), wherein the cover body (20) covers at a location of the recess (30), and forms an accommodating space for accommodating an overflow liquid with the cooling plate (10).

2. The liquid cooling plate assembly as claimed in claim 1, wherein an opening of the recess (30) faces upward, and the cover body (20) covers above the recess (30).

3. The liquid cooling plate assembly as claimed in claim 2, wherein the interface (50) is located on a bottom surface of the recess (30).

4. The liquid cooling plate assembly as claimed in claim 2, wherein the cooling plate (10) comprises:
a body portion (11), wherein the body portion (11) has the cavity, and the interface (50) is located on an upper surface of the body portion (11); and
a side edge portion (12), wherein the side edge portion (12) is connected to the upper surface of the body portion (11) and extends upwards, the side edge portion (12) is arranged along a peripheral side of the body portion (11), and forms, together with the body portion (11), the recess (30) having the opening facing upward.

5. The liquid cooling plate assembly as claimed in claim 4, wherein the cover body (20) comprises:
a top plate (21), wherein the top plate (21) covers right above the recess (30); and
an abutting portion (22), wherein the abutting portion (22) is connected to a lower surface of the top plate (21) and extends downwards, and the abutting portion (22) is arranged along a peripheral side of the top plate (21) and is abutted against and attached to an inner wall of the side edge portion (12).

6. The liquid cooling plate assembly as claimed in claim 1, wherein two interfaces (50) are provided, and the two interfaces (50) are respectively arranged at two ends of the cooling plate (10), and the two interfaces (50) are respectively abutted against and fitted with the liquid cooling pipe (40) for liquid inlet and the liquid cooling pipe (40) for liquid outlet.

7. The liquid cooling plate assembly as claimed in claim 1, wherein the interface (50) is provided with an adapter portion, the adapter portion comprises a first section and a second section; one end of the first section is in communication with the cavity, one end of the second section is connected to the other end of the first section; and a certain included angle is formed between an axis direction of the second section and an axis direction of the first section, and the other end of the second section is connected to the liquid cooling pipe (40).

8. The liquid cooling plate assembly as claimed in any one of claims 1-7, wherein the recess (30) and the cover body (20) are further formed with a clearance channel for passing through of the liquid cooling pipe (40); and the liquid cooling plate assembly further comprises a flow blocking member (60), the flow blocking member (60) is arranged at the clearance channel, and blocks a space between the liquid cooling pipe (40) and a side wall of the clearance channel.

9. The liquid cooling plate assembly as claimed in claim 8, wherein the recess (30) comprises a main body area (31) and a clearance area (32), the main body area (31) is in communication with the clearance area (32), the interface (50) is located in the main body area (31), and the clearance area (32) is located on a side edge of the main body area (31); and a portion of the cover body (20) covers the clearance area (32), and forms the clearance channel together with the clearance area (32).

10. The liquid cooling plate assembly as claimed in claim 9, wherein the body portion (11) of the cooling plate (10) comprises a middle main body part, a protruding plate is formed on a side edge in a width direction of the middle main body part, and a size of each protruding plate is less than a size of the middle main body part; and the main body area (31) is located at the middle main body part, and the clearance area (32) is located at the protruding plate.

11. The liquid cooling plate assembly as claimed in claim 8, wherein the flow blocking member (60) is provided with a through hole, and the liquid cooling pipe (40) passes through the through hole.

12. The liquid cooling plate assembly as claimed in claim 8, wherein a positioning structure is provided on the recess (30) and/or the cover body (20), the positioning structure is located in the clearance channel, and the flow blocking member (60) is arranged at the positioning structure.

13. The liquid cooling plate assembly as claimed in claim 12, wherein the positioning structure comprises a protrusion (70) located on the cooling plate (10), and the protrusion (70) extends in a direction perpendicular to a direction in which the liquid cooling pipe (40) penetrates into the clearance channel.

14. The liquid cooling plate assembly as claimed in claim 13, wherein there are a plurality of protrusions (70), at least two protrusions (70) are arranged in the clearance channel, the plurality of protrusions (70) are spaced apart from each other, and the flow blocking member (60) is positioned in an interval between the plurality of protrusions (70).

15. The liquid cooling plate assembly as claimed in claim 8, wherein there are a plurality of clearance channels, and two opposite sides of the cooling plate (10) are both provided with the clearance channel.

16. The liquid cooling plate assembly as claimed in any one of claims 1-7, wherein the liquid cooling plate assembly further comprises a liquid leakage detection member (80) for detecting a liquid leakage state of the liquid cooling plate assembly, and the liquid leakage detection member (80) penetrates into the recess (30).

17. The liquid cooling plate assembly as claimed in claim 16, wherein the recess (30) comprises a main body area (31) and a clearance area (32), the main body area (31) is in communication with the clearance area (32), the interface (50) is located in the main body area (31), and the clearance area (32) is located on a side edge of the main body area (31); and a portion of the cover body (20) covers the clearance area (32), and forms, together with the clearance area (32), the clearance channel for passing through of the liquid cooling pipe (40); and the liquid leakage detection member (80) penetrates into both the main body area (31) and the clearance area (32).

18. The liquid cooling plate assembly as claimed in claim 17, wherein there are a plurality of clearance channels, and two opposite sides of the cooling plate (10) are both provided with the clearance channel; and the liquid leakage detection member (80) sequentially passes through the clearance area (32) and the main body area (31) at one side, and the clearance area (32) at the other side.

19. The liquid cooling plate assembly as claimed in claim 16, wherein the liquid leakage detection member (80) penetrates and extends along a side edge of the recess (30).

20. The liquid cooling plate assembly as claimed in claim 16, wherein the liquid leakage detection member (80) penetrates into the recess (30) in an S shape.

21. The liquid cooling plate assembly as claimed in claim 1, wherein
an opening of the recess (30) faces upward, and the cover body (20) covers above the recess (30);
the recess (30) comprises a main body area (31) and a clearance area (32), the main body area (31) is in communication with the clearance area (32), the interface (50) is located in the main body area (31), and the clearance area (32) is located on a side edge of the main body area (31); a portion of the cover body (20) covers the clearance area (32), and forms, together with the clearance area (32), the clearance channel for passing through of the liquid cooling pipe (40);
the liquid cooling plate assembly further comprises a flow blocking member (60), the flow blocking member (60) is arranged at the clearance channel, and blocks a space between the liquid cooling pipe (40) and a side wall of the clearance channel; and
the liquid cooling plate assembly further comprises a liquid leakage detection member (80) for detecting a liquid leakage state of the liquid cooling plate assembly, and the liquid leakage detection member (80) penetrates into the recess (30);
the liquid leakage detection member (80) penetrates into both the main body area (31) and the clearance area (32); and
the liquid leakage detection member (80) penetrates and extends along a side edge of the recess (30), or penetrates into the recess (30) in an S shape.

22. A server, comprising the liquid cooling plate assembly as claimed in any one of claims 1-21.

23. A data center, comprising a plurality of servers as claimed in claim 22, the plurality of servers are electrically connected by switches.
